# EUROPEAN PATENT APPLICATION

(11) **EP 4 572 118 A1**
(43) Date of publication of application: **18.06.2025**
(21) Application number: 23874526.9
(22) Date of filing: 09.08.2023
(51) Int. Cl.: H02M 7/48, H01L 23/02

(54) **ELECTRIC DEVICE**

(30) Priority: 06.10.2022 JP 2022161663
(71) Applicant: Hitachi, Ltd., Tokyo 100-8280 (JP)
(72) Inventor: YOSHITAKE, Yuuichiro, Tokyo 100-8280 (JP); KUSUKAWA, Junpei, Tokyo 100-8280 (JP); KAMIZUMA, Hiroshi, Tokyo 100-8280 (JP); KAWASHIMA, Tetsuya, Tokyo 100-8280 (JP); NAKATSU, Kinya, Tokyo 100-8280 (JP)
(74) Representative: Manitz Finsterwald Patent- und Rechtsanwaltspartnerschaft mbB
(86) International application number: PCT/JP2023/029046
(87) International publication number: WO 2024/075393

(57) **Abstract**

This electric device comprises electrical components (1, 60), an electrical component support unit (21), and an outside frame (90). An interior space (92) is formed between the electrical component support unit and the outside frame, the electrical components are installed in the internal space, and gas is enclosed in the internal space at a water vapor pressure of 0.60 Pa or less. In electric devices in which electrical components such as electrolytic capacitors (60), etc., are disposed in a closed space, this makes it possible to prevent the occurrence of condensation on the wall surfaces, etc., of the closed space, and to prevent damage to the electrical components due to air pressure.

## Description

### Technical Field

The present disclosure relates to an electrical apparatus.

### Background Art

In order to achieve zero-carbon society, CO₂ emission control is strongly demanded in each country, and motorization of a power system is actively promoted as a substitute for an engine using fossil fuel.

Application of power electronics apparatuses has been studied in all engine-driven mobility products, and improvement of power density thereof has been required. Accordingly, power electronics apparatuses are required to be applicable to any climate in the world. In aircraft, environmental resistance capable of coping with a sudden change in altitude is essential. At the same time, improvement in cooling performance, increase in voltage, weight reduction, and the like are required, and technology development for this purpose is in progress.

PTL 1 discloses the air conditioner including an inverter device that drives an electric compressor. T inverter device has a condensation prevention structure of its case that accommodates a power element and a control circuit that controls the power element. The case is filled with an inert gas. PTL 1 describes that the case is filled with the inert gas at room temperature and at a pressure slightly higher than atmospheric pressure.

PTL 2 discloses a power conversion device for an aircraft. The power conversion deice includes a sealed casing including a gas inlet valve and a gas outlet valve, a power semiconductor module disposed in an internal space of the sealed casing, and a dry gas filling the internal space of the sealed casing. PTL 2 further discloses that a dry gas is injected from ambient pressure (for example, atmospheric pressure) outside the sealed casing, and thus the internal space of the sealed casing has a set pressure.

### Citation List

### Patent Literature

PTL 1: JP 2004-219031 A
PTL 2: JP Patent No. 6878712

### Summary of Invention

### Technical Problem

PTL 1 and PTL 2 disclose means that sets the air pressure in a container in which an electrical component is disposed to be higher than the atmospheric pressure. However, depending on the types of electrical components, some electrical components are damaged when the air pressure becomes high.

An object of the present disclosure is to prevent condensation from occurring on a wall surface or the like of an sealed space and to prevent damage of an electrical component due to atmospheric pressure in an electrical apparatus in which an electrical component such as an electrolytic capacitor is disposed in the sealed space.

### Solution to Problem

An electrical apparatus of the present disclosure includes an electrical component, an electrical component support unit, and an outside frame. Between the electrical component support unit and the outer frame an internal space is provided, and the electrical component is installed in the internal space. The internal space contains a sealed gas having a water vapor pressure of 0.60 kPa or less.

### Advantageous Effects of Invention

According to the present disclosure, in the electrical apparatus in which the electrical component such as the electrolytic capacitor is disposed in the sealed space, condensation can be prevent from occurring on a wall surface or the like of the sealed space, and damage of the electrical component due to atmospheric pressure can be prevented.

### Brief Description of Drawings

[FIG. 1] FIG. 1 is a schematic cross-sectional view illustrating an electrical apparatus according to a first embodiment.
[FIG. 2] FIG. 2 is a schematic cross-sectional view illustrating an electrical apparatus according to a second embodiment.
[FIG. 3] FIG. 3 is a schematic cross-sectional view illustrating an electrical apparatus according to a third embodiment.
[FIG. 4] FIG. 4 is a schematic cross-sectional view illustrating an electrical apparatus according to a fourth embodiment.
[FIG. 5] FIG. 5 is a schematic cross-sectional view illustrating an electrical apparatus according to a fifth embodiment.

### Description of Embodiments

Hereinafter, embodiments of the present disclosure will be described in detail with reference to the drawings.

Note that, in this specification, an electrical apparatus and an electronic apparatus that function using electricity as an energy source are generally referred to as an "electrical apparatus". The electrical apparatus also include a power conversion device.

### [First Embodiment]

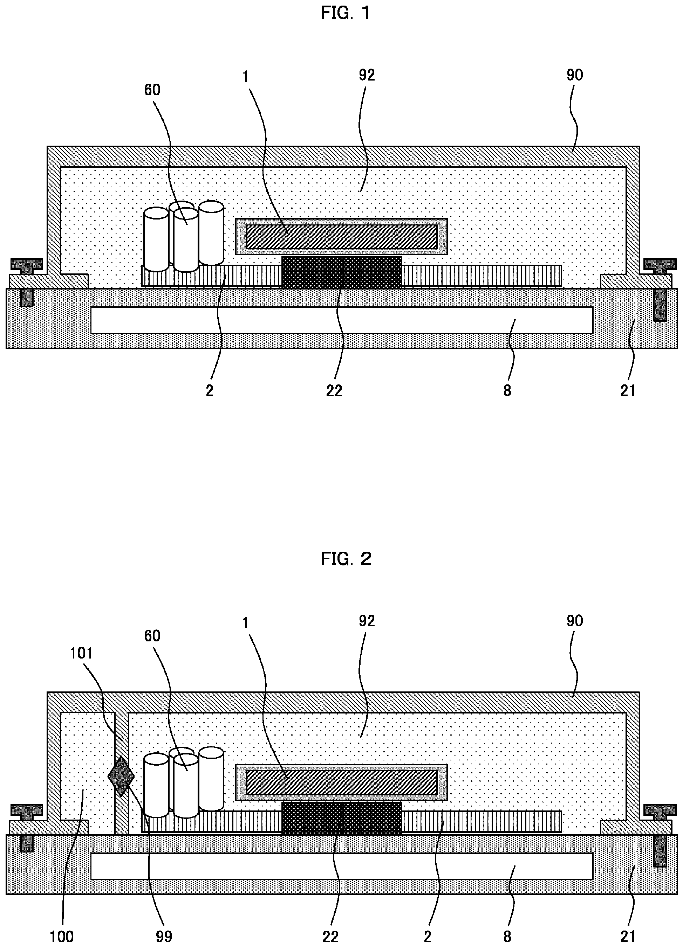

FIG. 1 is a schematic cross-sectional view illustrating an electrical apparatus according to a first embodiment.

The electrical apparatus illustrated in this drawing is a power conversion device having a liquid cooling mechanism. The power conversion device includes a switching element 1, an electrolytic capacitor 60, a substrate 2, a substrate support unit 21, a heat conducting member 22, and outside frame 90.

A liquid flow channel 8 is provided in the substrate support unit 21. The substrate 2 and the heat conducting member 22 are disposed in the substrate support unit 21. The switching element 1 is disposed to be in contact with the heat conducting member 22. The electrolytic capacitor 60 is disposed on the substrate 2.

The outside frame 90 is fixed to the substrate support unit 21 to cover the switching element 1, the electrolytic capacitor 60, the substrate 2, and heat conducting member 22. As a result, an internal space 92 is formed between the substrate support unit 21 and the outside frame 90. The internal space 92 is completely sealed so that no air enters from or exits to the outside. The switching element 1, the electrolytic capacitor 60, the substrate 2, and the heat conducting member 22 are configured not to be in contact with the outside frame 90. A gas that does not substantially contain water vapor, such as dry air, is sealed into the internal space 92. Accordingly, condensation does not occur on the inner wall surface of the outside frame 90. The water vapor pressure of the gas sealed into the internal space 92 is desirably 0.60 kPa or less, more desirably 0.080 kPa or less, and particularly desirably 0.0020 kPa or less. Here, the dry air has the same composition (it contains about 78 volume percent of nitrogen and about 21 volume percent of oxygen as main components) as that of normal air.

The switching element 1 includes a metal-oxide-semiconductor field-effect transistor (MOSFET) or a power module. The substrate support unit 21 is made of metal. Note that, in this specification, components, such as the switching element 1, that function by energization are collectively referred to as "electrical components". The electrical component includes a capacitor, a printed circuit board (PCB), and the like.

The outside frame 90 is made of metal such as aluminum alloy or stainless steel, and has strength as a cover of the switching element 1. The thickness of the outside frame 90 is desirably about 2 to 3 mm although it depends on the material.

Further, since the outside frame 90 is made of metal, even if a lightning strike occurs, a noise current is less likely to occur inside the power conversion device, and malfunction can be less likely to occur.

It is desirable that a contact area between the substrate support unit 21 and the heat conducting member 22, and a contact area between the switching element 1 and the heat conducting member 22 are enough wide so that heat generated in the switching element 1 is sufficiently removed. In addition, it is desirable that the liquid flow channel 8 of the substrate support unit 21 is disposed so that the liquid flowing through the liquid flow channel 8 can sufficiently remove heat from the heat conducting member 22. Examples of the liquid flowing through the liquid flow channel 8 include water, mineral oil, fluorocarbon coolant, and vegetable oil. Note that, in this specification, cooling of the power conversion device and the like with the liquid flowing through the liquid flow channel 8 is described, but a cooling mechanism of the electrical apparatus of the present disclosure is not limited thereto. The cooling mechanism may be achieved by a gas such as air, a refrigerant with a phase change, or the like. Specifically, the cooling mechanism may be achieved by forced-air cooling or by using a heat pipe

The electrolytic capacitor 60 is used for smoothing and filtering in the power conversion device. As such a capacitor, a ceramic capacitor, a film capacitor, a hybrid capacitor, or the like is also used. Capacitors other than those exemplified here may be used, and the type thereof is not limited.

In the case of the electrolytic capacitor 60, a valve may be provided in the electrolytic capacitor 60 to prevent damage due to an increase in atmospheric pressure. In this case, the operation of the valve of the electrolytic capacitor 60 may be hindered when the pressure of the gas in the internal space 92 of the sealed power conversion device increases due to a temperature rise or the like caused by the operation. Therefore, in a state where the power conversion device is not energized, in other words, in a state where heat is not generated and the temperature is not high in the power conversion device, it is desirable to finely adjust the air pressure of the internal space 92 to be less than the atmospheric pressure. That is, when the power conversion device is not operated, it is desirable to set the initial pressure of the internal space 92 to a slightly negative pressure.

As for electrical components other than the electrolytic capacitor 60, by setting the internal space 92 to have a negative pressure, pressure rise during operation can be offset, and damage of each electrical component can be prevented.

The substrate support unit 21 having the liquid flow channel 8 is desirably set to have the ground potential. The substrate support unit 21 is desirably made of metal such as aluminum alloy, stainless steel, or copper alloy.

Under the low atmospheric pressure environment, a partial discharge inception voltage greatly decreases as compared with under the atmospheric pressure. Therefore, it is necessary to apply a solid or liquid having a partial discharge inception voltage about 10 times higher than that of air on the surface to which the voltage is applied and the surface to be grounded.

In a case where partial discharge inception is feared due to high voltage, high electric field stress, or the like, for example, a portion with high electrical stress, such as the periphery of the switching element 1 is desirably covered with a solid insulating material such as silicone. This makes it possible to make partial discharge under low atmospheric pressure less likely to occur. In addition, a polyphenylene sulfide resin (PPS), an epoxy resin, an unsaturated polyester, and the like are suitable as the solid insulating material.

The gas sealed in the internal space 92 may be nitrogen, argon, carbon dioxide, nitrogen dioxide, or the like, in addition to dry air. Desirably, the gas is not liquefied even at -70°C. Further, these gases may be mixed and sealed.

Furthermore, as the gas sealed into the internal space 92, one obtained by adding oxygen to dry air to make the oxygen concentration higher than the atmospheric air (oxygen concentration: 21 volume percent) may be used. By increasing the oxygen concentration, electron adhesiveness of a gas to be sealed is increased, discharge is easily suppressed, and insulation is improved. As the gas having such high electron adhesiveness, carbon dioxide, sulfur hexafluoride, carbon monoxide, or the like may be used in addition to oxygen. In addition to the sulfur hexafluoride described above, a halogen series-containing gas or the like may be mixed. As the halogen series-containing gas containing fluorine, chlorine, iodine, or the like, a fluorinated gas, such as BF₃ or CF₄, a chloride gas, a Freon gas, or the like is known.

Further, the internal space 92 may be depressurized to be in a vacuum state. In this case, it is more desirable as the degree of vacuum is higher, but specifically, 1 Pa or less is desirable, and 0.1 Pa or less is more desirable. By bringing the internal space 92 into a vacuum state, the water vapor pressure is also reduced, so that condensation and the like can be prevented. In addition, it is possible to prevent corrosion due to condensation, malfunction due to the lightning surge, and the like.

### [Second Embodiment]

In the present embodiment, only a part of the configuration different from that in the first embodiment will be described.

FIG. 2 is a schematic cross-sectional view illustrating an electrical apparatus according to the second embodiment.

In the drawing, in addition to the internal space 92, a low-pressure chamber 100 is provided between the substrate support unit 21 and the outside frame 90. The internal space 92 and the low-pressure chamber 100 are separated from each other by a partition plate 101. A vent filter 99 is provided in the partition plate 101.

The electrical component is installed in the internal space 92. The air pressure is set to be lower in the low-pressure chamber 100 than in the internal space 92. With such a configuration, in a case where the air pressure in the internal space 92 increases due to the heat generation in the electrical components, the vent filter 99 is opened and the gas in the internal space 92 can be allowed to flow out to the low-pressure chamber 100. In this case, in the initial state, the air pressure of the internal space 92 can be made higher than the atmospheric pressure (1 atm).

### [Third Embodiment]

In the present embodiment, only a part of the configuration different from that in the first embodiment will be described.

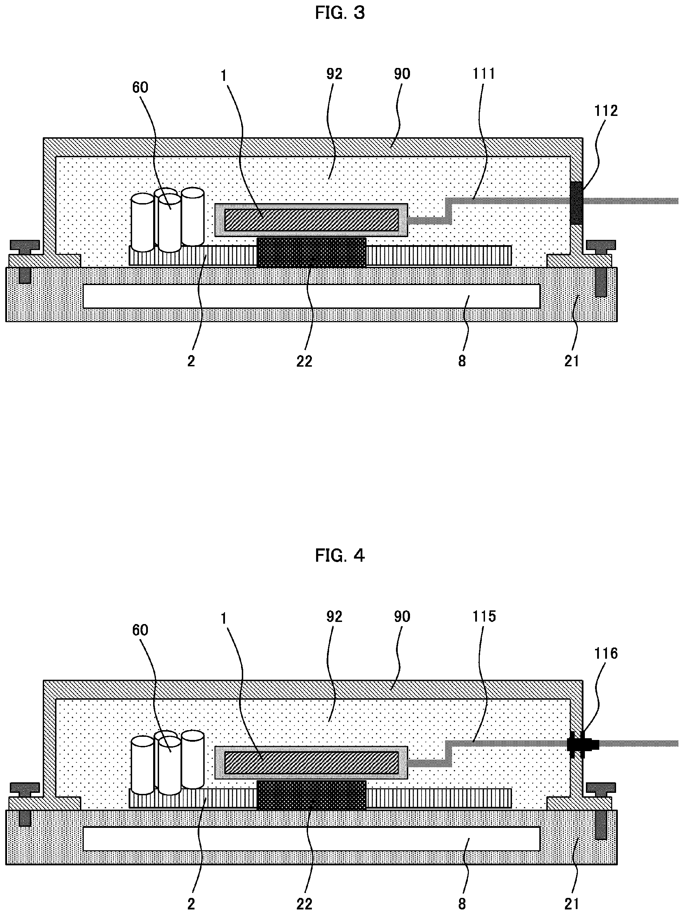

FIG. 3 is a schematic cross-sectional view illustrating an electrical apparatus according to the third embodiment.

In the drawing, the switching element 1 is electrically connected to the outside via a cable 111. The cable 111 is obtained by covering conductors. An extract port of the cable 111 provided in the outside frame 90 is sealed by a silicone FIPG 112 or the like to secure airtightness of the internal space 92. Here, FIPG is an abbreviation of Formed In Place Gasket.

### [Fourth Embodiment]

In the present embodiment, only a part of the configuration different from that in the third embodiment will be described.

FIG. 4 is a schematic cross-sectional view illustrating an electrical apparatus according to the fourth embodiment.

In the drawing, the switching element 1 is electrically connected to the outside via a bus bar 115. A cable may be used instead of the bus bar 115. The cable is obtained by covering conductors.

A connecting portion of the bus bar 115 provided in the outside frame 90 is a Bayonet Neill-Concelman (BNC) connector 116. Accordingly, airtightness of the internal space 92 is ensured. Further, connection work can be facilitated.

### [Fifth Embodiment]

In the present embodiment, only a part of the configuration different from that in the first embodiment will be described.

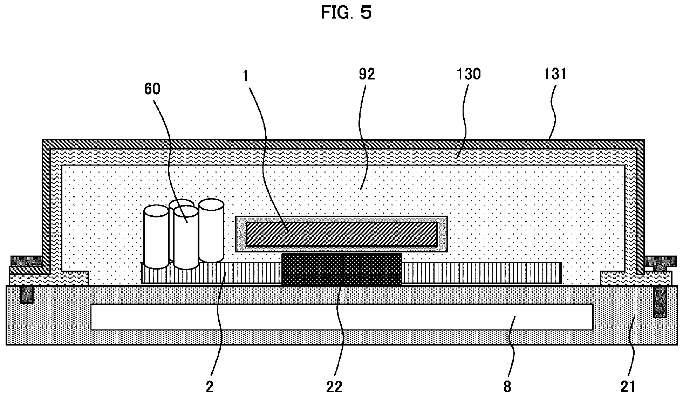

FIG. 5 is a schematic cross-sectional view illustrating an electrical apparatus according to the fifth embodiment.

In this drawing, a frame in which an outer wall surface of a flame-retardant resin frame 130 is covered with a metal film 131 is used instead of the outside frame 90 (made of metal) of FIG. 1. This frame is also referred to as an "outside frame". The metal film 131 is preferably made of aluminum, iron, nickel, or the like. The metal film 131 may also be provided on the inner wall surface of the flame-retardant resin frame 130. Such a configuration makes it possible to prevent ignition at the time of a lightning strike, inflow of a noise, and the like. Further, the weight of the electrical apparatus can be reduced.

Suitable examples of a material of the flame-retardant resin frame 130 are a foamed resin such as polyurethane, polystyrene, polyethylene, polypropylene, or silicone. Further, a vacuum heat insulating material or the like using glass wool, silica powder, or the like as a core material is also desirable. Note that the material of the flame-retardant resin frame 130 is not limited to them.

Instead of the flame-retardant resin frame 130, a metal frame may be used.

In the above embodiment, the electrical apparatus includes the substrate 2, the substrate support unit 21, and the heat conducting member 22. However, the electrical apparatus of the present disclosure may not necessarily include these components, and may include a member that supports the electrical components, instead of the substrate support unit 21. The internal space may be formed between this member and the outside frame 90. In this specification, the substrate support unit 21 and the member are collectively referred to as the "electrical component support unit".

Note that the electrical apparatus of the present disclosure is also applicable to general mobilities, such as aircraft, transportation equipment, construction machine, and the like.

Desirable embodiments of the electrical apparatus of the present disclosure will be collectively described below.

The electrical component includes an electrolytic capacitor.

The air pressure in the internal space is set to be lower than the atmospheric pressure.

The gas in the internal space is dry air, nitrogen, argon, carbon dioxide, nitrogen dioxide, or a mixture of any two or more of them.

The internal space is in a vacuum state.

The outside frame contains at least any one of polyurethane, polystyrene, polyethylene, polypropylene, and silicone, and is configured by covering any one of them with a metal film.

The outside frame includes a vacuum heat insulating material containing at least any one of glass wool and silica powder as a core material.

The oxygen concentration of the gas in the internal space is higher than 21 volume percent.

The gas in the internal space contains at least any one of carbon dioxide, sulfur hexafluoride, carbon monoxide, and a halogen series-containing gas.

The low-pressure chamber adjacent to the internal space is provided between the electrical component support unit and the outside frame, and the air pressure is set to be lower in the low-pressure chamber than in the internal space. The vent filter is provided between the internal space and the low-pressure chamber.

The electrical component is electrically connected to the outside via the cable, and the extraction port of the cable provided in the outside frame is sealed with silicone FIPG.

The electrical component is electrically connected to the outside via the cable or the buss bar, and a BNC connector is provided at the extraction port of the cable or the connecting portion of the bus bar provided in the outside frame.

### Reference Signs List

- 1: switching element
- 2: substrate
- 8: liquid flow channel
- 21: substrate support unit
- 22: heat conducting member
- 60: electrolytic capacitor
- 90: outside frame
- 92: internal space
- 99: vent filter
- 100: low-pressure chamber
- 101: partition plate
- 111: cable
- 112: silicone FIPG
- 115: bus bar
- 116: BNC connector
- 130: flame-retardant resin frame
- 131: metal film

## Claims

1. An electrical apparatus, comprising:
an electrical component;
an electrical component support unit; and
an outside frame,
wherein between the electrical component support unit and the outside frame, an internal space is provided,
wherein the electrical component is installed in the internal space, and
wherein in the internal space a gas having a water vapor pressure of 0.60 kPa or less is sealed.

2. The electrical apparatus according to claim 1, wherein the electrical component includes an electrolytic capacitor.

3. The electrical apparatus according to claim 1, wherein the internal space has an air pressure set to be less than an atmospheric pressure.

4. The electrical apparatus according to claim 1, wherein the gas includes dry air, nitrogen, argon, carbon dioxide, nitrogen dioxide, or a mixture of at least any two kinds of them.

5. The electrical apparatus according to claim 1, wherein the internal space is in a vacuum state.

6. The electrical apparatus according to claim 1, wherein the outside frame includes at least any one of polyurethane, polystyrene, polyethylene, polypropylene, and silicone, and is configured by covering at least any one of them with a metal film.

7. The electrical apparatus according to claim 1, wherein the outside frame includes a vacuum heat insulating material containing at least any one of glass wool and silica powder as a core material.

8. The electrical apparatus according to claim 1, wherein the gas has an oxygen concentration higher than 21 volume percent.

9. The electrical apparatus according to claim 1, wherein the gas contains at least any one of carbon dioxide, sulfur hexafluoride, carbon monoxide, and a halogen series-containing gas.

10. The electrical apparatus according to claim 1,
wherein between the electrical component support unit and the outside frame, a low-pressure chamber adjacent to the internal space is provided,
wherein the low-pressure chamber has an air pressure set to be lower than that in the internal space, and
wherein between the internal space and the low-pressure chamber, a vent filter is provided.

11. The electrical apparatus according to claim 1,
wherein the electrical component is electrically connected to an outside via a cable, and
wherein the outside frame is provided with an extraction port of the cable, the extraction port being sealed with silicone Formed In Place Gasket (FIPG).

12. The electrical apparatus according to claim 1,
wherein the electrical component is electrically connected to an outside via a cable or a bus bar, and
wherein the outside frame is provided with an extraction port of the cable or a connecting portion of the bus bar, the extraction port or the connecting portion being provided with a Bayonet Neill-Concelman (BNC) connector.

13. The electrical apparatus according to claim 1, including a power conversion device.
